# EUROPÄISCHE PATENTSCHRIFT

(11) **EP 0 361 192 B1**
(45) Veröffentlichungstag und Bekanntmachung des Hinweises auf die Patenterteilung: **23.02.1994**
(21) Anmeldenummer: 89116801.5
(22) Anmeldetag: 11.09.1989
(51) Int. Cl.: H05K 3/02, H05K 3/42

(54) **Verfahren zur Herstellung von Leiterplatten**
Method of making circuit boards
Procédé de fabrication de plaques de circuit

(30) Priorität: 29.09.1988 DE 3833094
(43) Veröffentlichungstag der Anmeldung: 04.04.1990
(60) Teilanmeldung: 91114359.2
(73) Patentinhaber: SIEMENS AKTIENGESELLSCHAFT, 80333 München (DE)
(72) Erfinder: Mattelin, Antoon, B-8020 Oostkamp (BE)

(56) Entgegenhaltungen:
- EP-A- 0 062 300
- US-A- 4 264 419
- US-E- 30 434

## Beschreibung

Die Erfindung betrifft ein Verfahren zur Herstellung von Leiterplatten, bei welchem eine ganzflächig auf eine Metallschicht aufgebrachte metallische Ätzresistschicht mittels elektromagnetischer Strahlung selektiv wieder entfernt wird und das Leiterbahnmuster durch Abätzen der derart freigelegten Metallschicht strukturiert werden kann.

Ein derartiges Verfahren geht beispielsweise aus der EP-A-0 062 300 hervor. Um bei diesem bekannten Verfahren die Metallschicht zwischen den Leiterbahnen durch Ätzen vollständig entfernen zu können, muß zuvor die darüberliegende Ätzresistschicht ebenfalls vollständig entfernt werden. Diese Entfernung der Ätzresistschicht, die vorzugsweise in einem Scanverfahren mit dem Laser vorgenommen werden soll, ist jedoch aufwendig und zeitraubend. Dies trifft insbesondere dann zu, wenn die Leiterbahnen relativ weit auseinander liegen und die Flächen der mit dem Laser abzutragenden Ätzresistschicht somit relativ groß sind.

Der Erfindung liegt die Aufgabe zugrunde, das bekannte Verfahren zur Herstellung von Leiterplatten so zu verbessern, daß die selektive Entfernung der metallischen Ätzresistschicht mittels elektromagnetischer Strahlung rasch und mit geringem Aufwand vorgenommen werden kann.

Die Lösung dieser Aufgabe erfolgt durch folgende Verfahrensschritte:
a) auf ein elektrisch isolierendes Substrat werden nacheinander eine Metallschicht und eine erste Ätzresistschicht aufgebracht;
b) die erste Ätzresistschicht wird in den unmittelbar an das spätere Leiterbahnmuster angrenzenden Bereichen mittels elektromagnetischer Strahlung wieder entfernt;
c) die im Schritt b) freigelegten Bereiche der Metallschicht werden bis zur Oberfläche des Substrats weggeätzt;
d) auf die verbleibenden Bereiche der Metallschicht wird eine zweite metallische Ätzresistschicht aufgebracht;
e) die nicht dem Leiterbahnmuster entsprechenden Bereiche werden anodisch kontaktiert;
f) in den anodisch kontaktierten Bereichen wird das gesamte Ätzresist elektrolytlisch abgetragen;
g) die im Schritt e) freigelegten Bereiche der Metallschicht werden bis zur Oberfläche des Substrates weggeätzt.

Bei dem erfindungsgemäßen Verfahren werden also im Unterschied zu der bisherigen Vorgehensweise nur die unmittelbar an das spätere Leiterbahnmuster angrenzenden Bereiche der ersten Ätzresistschicht mittels elektromagnetischer Strahlung entfernt. Die Konturbeschreibung mittels der elektromagnetischen Strahlung ist also als eine enge Umfahrung des Leiterbahnmusters anzusehen, die im Hinblick auf die geringe Flächenausdehnung der abzutragenden ersten Ätzresistschicht rasch vorgenommen werden kann. Nach dem Ätzen verbleiben dann allerdings noch zunächst zwischen den Leiterbahnen die unerwünschten Bereiche der Metallschicht, die jedoch nach einer Umkapselung der späteren Leiterbahnen mit einer zweiten Ätzresistschicht mit geringem Aufwand anodisch kontaktiert und in einer geeigneten Lösung von ihrer schützenden Atzresistschicht befreit werden können. Die Umkapselung der Leiterbahnen mit Ätzresist bleibt dabei bestehen, so daß die unerwünschten Bereiche der Metallschicht zwischen den Leiterbahnen dann problemlos abgeätzt werden können.

Hauptbedingung für das erfindungsgemäße Verfahren ist eine totale Isolierung der Leiterbahnen auf dem Substrat, d.h. die Leiterbahnen müssen Inseln darstellen, die nicht anodisch kontaktiert werden dürfen. Demgegenüber müssen alle unerwünschten Metallflächen elektrisch miteinander verbunden sein, was jedoch durch eine entsprechende Gestaltung der Leiterbahnmuster und/oder durch Klemmen, Kontaktbrücken oder dergleichen problemlos erreicht werden kann.

Gemäß einer bevorzugten Ausgestaltung des erfindungsgemäßen Verfahrens ist vorgesehen, daß nach dem im Schritt c) vorgenommenen Wegätzen die erste Ätzresistschicht vor dem Aufbringen der zweiten Ätzresistschicht vollständig entfernt wird. Durch dieses Strippen der ersten Ätzresistschicht wird das Aufbringen der zweiten Ätzresistschicht auf die späteren Leiterbahnen und insbesondere auch auf die Leiterbahnflanken begünstigt, d.h. beim nachfolgenden Ätzvorgang ist ein sicherer Schutz der Leiterbahnen gewährleistet.

Gemäß einer weiteren bevorzugten Ausgestaltung des erfindungsgemäßen Verfahrens ist vorgesehen, daß die Metallschicht durch stromlose und galvanische Abscheidung von Kupfer auf das Substrat aufgebracht wird. Diese Vorgehensweise ist insbesondere dann von Vorteil, wenn Leiterplatten mit Durchkontaktierungen hergestellt werden sollen und durch die stromlose und galvanische Abscheidung von Kupfer auch eine Metallisierung der entsprechenden Durchkontaktierungslöcher erzielt wird.

Es hat sich weiterhin als besonders günstig erwiesen, wenn für die erste Ätzresistschicht und die zweite Ätzresistschicht Zinn oder eine Zinn-Blei-Legierung verwendet wird. Derartige Ätzresistschichten lassen sich einerseits beispielsweise mit einem Laser leicht strukturieren, wahrend sie andererseits beim Ätzen einen sicheren Schutz der darunterliegenden Metallschicht gewährleisten.

Die erste Ätzresistschicht und die zweite Ätzresistschicht werden vorzugsweise durch stromlose Metallabscheidung aufgebracht, da dies auf besonders wirtschaftliche Weise durchgeführt werden kann und dabei auch ein sicherer Schutz der Metallschicht innerhalb der Durchkontaktierungen erzielt wird.

Die elektromagnetische Strahlung wird vorzugsweise durch einen Laser erzeugt, da Laserstrahlen für ein Abtragen bzw. Verdampfen der ersten Ätzresistschicht in den erwünschten Bereichen besonders geeignet sind. Die Bewegung des Laserstrahls relativ zum Substrat sollte dann vorzugsweise frei programmierbar sein, d.h., daß eine Konturbeschreibung des Leiterbahnmusters mit dem Laserstrahl rasch durchgeführt und insbesondere auch leicht variiert werden kann.

Im Hinblick auf eine weitere Steigerung der Wirtschaftlichkeit des erfindungsgemäßen Verfahrens ist es auch besonders günstig, wenn ein dreidimensionales, spritzgegossenes Substrat mit eingespritzten Durchkontaktierungslöchern verwendet wird. Derartige Substrate können dann durch Spritzgießen in großer Anzahl wirtschaftlich gefertigt werden, während die dreidimensionale Ausgestaltung der Substrate bzw. Leiterplatten bei einer Strukturerzeugung mittels elektromagnetischer Strahlung kein Problem darstellt.

Ein Ausführungsbeispiel der Erfindung ist in der Zeichnung dargestellt und wird im folgenden näher beschrieben.

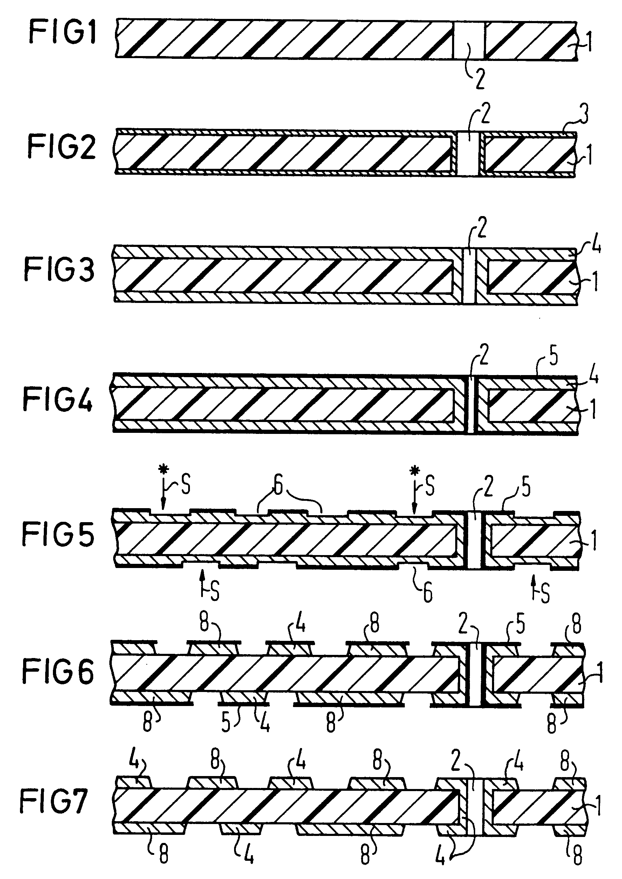

Die Figuren 1 bis 10 zeigen in stark vereinfachter schematischer Darstellung die verschiedenen Verfahrensstadien bei der Herstellung von Leiterplatten.

Bei dem in Fig. 1 dargestellten Substrat 1 handelt es sich um einen Ausschnitt eines Basismaterials mit eingespritzten Durchkontaktierungslöchern 2. Als Materialien für die Substrate derartiger Leiterplatten sind insbesondere hochtemperaturbeständige Thermoplaste geeignet, wobei im geschilderten Ausführungsbeispiel glasfaserverstärktes Polyetherimid verwendet wurde.

Das in Fig. 1 dargestellte Substrat 1 wurde zunächst zur Erhöhung der Haftfestigkeit der später aufzubringenden Leiterbahnen und Durchkontaktierungen gebeizt und anschließlich gereinigt. Dabei wurden sowohl für das Beizen als auch für die Reinigung des Substrats 1 handelsübliche Bäder verwendet, wobei das Beizbad speziell auf den Werkstoff Polyethimid abgestimmt war.

Nach dem Beizen und Reinigen des Substrats 1 erfolgte dessen Bekeimung, die in Fig. 2 als dünne Schicht 3 aufgezeigt ist. Es ist ersichtlich, daß die Bekeimung 3 auf die Oberfläche des Substrats 1 und auf die Wandungen der Durchkontaktierungslöcher 2 aufgebracht wurde. Das Aufbringen der Bekeimung 3 erfolgte durch Eintauchen des Substrates 1 in ein PdCl₂-SnCl₂-Bad. Für das Aufbringen der Bekeimung 3 haben sich aber auch handelsübliche Bäder auf der Basis palladiumorganischer Verbindungen als geeignet erwiesen.

Nach dem Aufbringen der Bekeimung 3 wird diese aktiviert, wobei es sich hier um ein in der Additivtechnik übliches Reduzieren bzw. Beschleunigen handelt. Anschließend wurde gemäß Fig. 3 durch außenstromlose chemische Metallabscheidung eine äußerst dünne Schicht aufgebracht. Es ist ersichtlich, daß auch diese in einem handelsüblichen stromlosen Kupferbad aufgebrachte Grundschicht die Oberfläche des Substrats 1 und die Wandungen der Durchkontaktierungslöcher 2 überzieht.

Anschließend wird vollflächig stromlos verkupfert und galvanisch mit Kupfer verstärkt wodurch insgesamt eine Metallschicht 4 entsteht, die beispielsweise eine Stärke von 30 Mikrometern aufweist.

Gemäß Fig. 4 wird dann auf die Metallschicht 4 durch stromlose Metallabscheidung eine erste Ätzresistschicht 5 aufgebracht, die im beschriebenen Ausführungsbeispiel aus Zinn besteht.

Gemäß Fig. 5 wird die erste Ätzresistschicht 5 dann mit Hilfe eines Nd-YAG-Lasers in einem Scanverfahren strukturiert, wobei die Strahlung durch Pfeile 5 lediglich angedeutet ist. Es ist zu erkennen, daß die Entfernung der Ätzresistschicht 5 auf die unmittelbar an das spätere Leiterbahnmuster angrenzenden Bereiches 6 begrenzt ist.

Nach der geschilderten selektiven Entfernung der ersten Ätzresistschicht 5 werden die hierbei freigelegten Bereiche der Metallschicht 4 durch Ätzen entfernt, wobei hierfür in der Subtrakivtechnik übliche Ätzlösungen eingesetzt werden können. Fig. 6 zeigt, daß bei diesem Ätzschritt das Leiterbahnmuster bereits entsteht, wobei allerdings zwischen den Leiterbahnen noch unerwünschte Bereiche 8 der Metallschicht 4 verblieben sind.

Nach dem aus Fig. 7 ersichtlichen bevorzugten Strippen der ersten Ätzresistschicht 5 wird gemäß Fig. 8 auf die verbliebenen Bereiche der Metallschicht 4, also auch auf die unerwünschten Bereiche 8 eine zweite metallische Ätzresistschicht 7 aufgebracht, die im dargestellten Ausführungsbeispiel wiederum aus Zinn besteht und auch die Flanken der Leiterbahnen schützt. Gemäß Fig. 9 werden anschließend sämtliche unerwünschten Bereiche 8 zwischen den Leiterbahnen anodisch kontaktiert, wobei diese anodische Kontaktierung durch ein Pluszeichen angedeutet ist. Dadurch kann dann in einer geeigneten Elektrolytlösung beispielsweise in einer Bor-Flourwasserstofflösung die zweite Ätzresistschicht 7 in den unerwünschten Bereich 8 elektrolytisch aufgelöst werden, so wie es aus Fig. 9 ersichtlich ist.

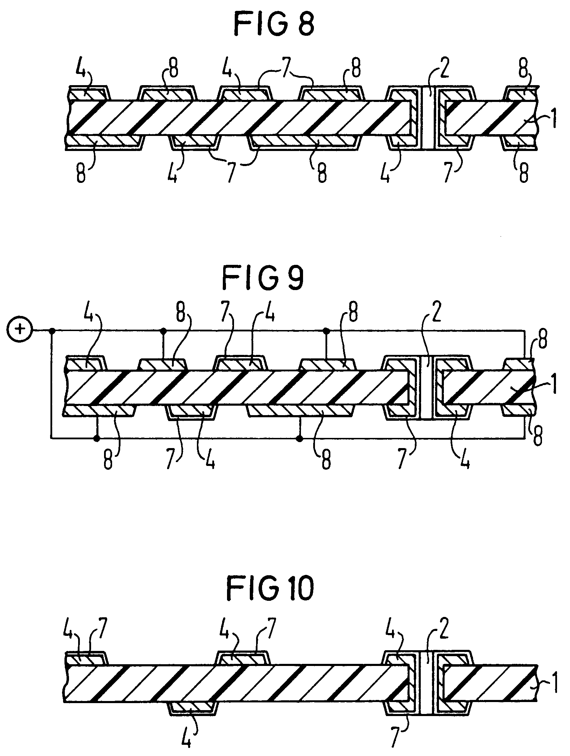

Bei dem vorstehend geschilderten selektiven Abtragen der zweiten Ätzresistschicht 7 gehen die Bereiche der Ätzresistschicht 7 auf den Leiterbahnen nicht in Lösung. Somit können in einem nächsten Ätzvorgang die freigelegten unerwünschten Bereiche 8 der Metallschicht 4 bis zur Oberfläche des Substrats 1 abgeätzt werden. Gemäß Fig. 10 bleiben dann auf dem Substrat 1 nur noch die den Leiterbahnmuster entsprechenden Bereiche der Metallschicht 4 auf den Substratflächen und in den Durchkontaktierungslöchern 2 übrig. Da die auf dem Leiterbahnmuster verbliebene zweite Ätzresistschicht 7 aus Zinn besteht, braucht sie nicht entfernt zu werden. Zumindest im Bereich der Durchkontaktierungen 2 wird durch das Zinn ein späteres Einlöten von Bauelementen begünstigt. Als letzter Schritt bei der Herstellung der Leiterplatten kann dann noch ein Tempern bei einer Temperatur von beispielsweise 130° C vorgenommen werden. Das Aufbringen eines Lötstopplacks mit anschließendem Heißverzinnen der verbliebenen Bereiche der Metallschicht 4 ist ebenfalls möglich. Gegebenenfalls könnte aber auch die verliebene zweite Ätzresistschicht 7 durch Strippen entfernt werden, wobei dieses Zinnstrippen ebenso wie die Entfernung der ersten Ätzresistschicht 5 vorzugsweise auf chemischen Wege vorgenommen wird.

Gemäß einer Variante des vor stehend beschriebenen Verfahrens wird auf die Metallschicht 4 eine organische Ätzresistschicht 5 aufgebracht. Vorzugsweise wird dann ein organisches Ätzresist verwendet, welches elektrophoretisch, d.h. durch Elektrotauchlackierung aufgebracht werden kann. Geeignet ist beispielsweise ein von der Firma Shipley unter dem Handelsnamen "Eagle TM" vertriebenes Resistmaterial. Die Strukturierung erfolgt dann auch hier wieder in einem Scanverfahren, so wie es in Fig. 5 durch die Pfeile S angedeutet ist.

## Patentansprüche

1. Verfahren zur Herstellung von Leiterplatten, mit folgenden Verfahrensschritten:
a) auf ein elektrisch isolierendes Substrat (1) werden nacheinander eine Metallschicht (4) und eine erste Ätzresistschicht (5) aufgebracht;
b) die erste Ätzresistschicht (5) wird in den unmittelbar an das spätere Leiterbahnmuster angrenzenden Bereichen (6) mittels elektromagnetischer Strahlung (S) wieder entfernt;
c) die im Schritt b) freigelegten Bereiche der Metallschicht (4) werden bis zur Oberfläche des Substrats (1) weggeätzt;
d) auf die verbleibenden Bereiche der Metallschicht (4) wird eine zweite metallische Ätzresistschicht (7) aufgebracht;
e) die nicht dem Leiterbahnmuster entsprechenden Bereiche (8) werden anodisch kontaktiert;
f) in den anodisch kontaktierten Bereichen (8) wird das gesamte Ätzresist elektrolytlisch abgetragen;
g) die im Schritt e) freigelegten Bereiche der Metallschicht (4) werden bis zur Oberfläche des Substrates (1) weggeätzt.

2. Verfahren nach Anspruch 1,
**dadurch gekennzeichnet,**
daß nach dem im Schritt c) vorgenommenen Ätzen die erste Ätzresistschicht (5) vor dem Aufbringen der zweiten Ätzresistschicht (7) vollständig entfernt wird.

3. Verfahren nach Anspruch 1 oder 2,
**dadurch gekennzeichnet,**
daß die Metallschicht (4) durch stromlose und galvanische Abscheidung von Kupfer auf das Substrat (1) aufgebracht wird.

4. Verfahren nach einem der vorhergehenden Ansprüche,
**dadurch gekennzeichnet,**
daß für die erste Ätzresistschicht (5) und die zweite Ätzresistschicht (7) Zinn oder eine Zinn-Blei-Legierung verwendet wird.

5. Verfahren nach einem der vorhergehenden Ansprüche,
**dadurch gekennzeichnet,**
daß die erste Ätzresistschicht (5) und die zweite Ätzresistschicht (7) durch stromlose Metallabscheidung aufgebracht werden.

6. Verfahren nach einem der vorhergehenden Ansprüche,
**dadurch gekennzeichnet,**
daß die elektromagnetische Strahlung (S) durch einen Laser erzeugt wird.

7. Verfahren nach Anspruch 6,
**dadurch gekennzeichnet,**
daß die Bewegung des Laserstrahls relativ zum Substrat (1) frei programmierbar ist.

8. Verfahren nach einem der vorhergehenden Ansprüche,
**dadurch gekennzeichnet,**
daß ein dreidimensionales, spritzgegossenes Substrat (1) mit eingespritzten Durchkontaktierungslöchern (2) verwendet wird.

## Claims

1. Process for the production of printed-circuit boards, with the following process steps:
a) a metal layer (4) and a first etch-resist layer (5) are applied successively onto an electrically insulating substrate (1);
b) the first etch-resist layer (5) is removed again, by electromagnetic radiation, in the areas bordering immediately on the subsequent conductor track pattern;
c) the areas of the metal layer (4) exposed in step b) are etched away as far as the surface of the substrate (1);
d) a second metallic etch-resist layer (7) is applied on the remaining areas of the metal layer(4);
e) the areas (8) not corresponding to the conductor track pattern are anodically contacted;
f) in the anodically contacted areas (8) the whole etch-resist is electrolytically eroded;
g) the areas of the metal layer (4) exposed in step e) are etched away as far as the surface of the substrate (1);

2. Process according to Claim 1, characterized in that, after the etching carried out in step c), the first etch-resist layer is completely removed before the second etch-resist layer (7) is applied.

3. Process according to Claim 1 or 2, characterized in that the metal layer (4) is applied by electroless and electrical deposition of copper on the substrate (1).

4. Process according to one of the preceding Claims, characterized in that tin or a tin-lead alloy is used for the first etch-resist layer (5) and the second etchresist layer (7).

5. Process according to one of the preceding Claims, characterized in that the first etch-resist layer (5) and the second etch-resist layer (7) are applied by electroless metal deposition.

6. Process according to one of the preceding Claims, characterized in that the electromagnetic radiation (S) is produced by a laser.

7. Process according to Claim 6, characterized in that the movement of the laser beam relative to the substrate (1) is freely programmable.

8. Process according to one of the preceding Claims, characterized in that a three-dimensional, injection-moulded substrate (1) with moulded-in through-plated holes is used.

## Revendications

1. Procédé de fabrication de plaques à circuits imprimés, comportant les phases opératoires suivantes :
a) une couche métallique (4) et une première couche (5) de résist à la corrosion sont déposées l'une après l'autre sur un substrat (1) électriquement isolant;
b) la première couche (5) de résist est supprimée dans les zones (6) directement voisines du modèle ultérieur de pistes conductrices, au moyen d'un rayonnement électromagnétique (S);
c) les zones de la couche métallique (4) dégagées dans la phase opératoire b) sont supprimées par attaque, jusqu'à la surface du substrat (1);
d) une seconde couche métallique (7) de résist est déposée sur les zones restantes de la couche métallique (4);
e) les zones (8) ne correspondant pas au modèle de pistes conductrices sont contactées anodiquement;
f) la totalité du résist est enlevé électrolytiquement sur les zones (8) contactées anodiquement;
g) les zones de la couche métallique (4) libérées dans la phase opératoire e) sont supprimées par attaque jusqu'à la surface du substrat (1).

2. Procédé suivant la revendication 1, caractérisé en ce que
après l'attaque effectuée dans la phase opératoire c), la première couche (5) de résist est entièrement supprimée, avant le dépôt de la deuxième couche (7) de résist.

3. Procédé suivant la revendication 1 ou 2, caractérisé en ce que
la couche métallique (4) est déposée sur le substrat (1) par dépôt galvanique, de cuivre opéré sous courant électrique.

4. Procédé suivant l'une des revendications précédentes, caractérisé en ce que
pour la première couche (5) de résist et la deuxième couche (7) de résist, on utilise de l'étain ou un alliage étainplomb.

5. Procédé suivant l'une des revendications précédentes, caractérisé en ce que,
la première couche (5) de résist et la deuxième couche (7) de résist sont déposées par dépôt métallique opéré sans courant électrique.

6. Procédé suivant l'une des revendications précédentes, caractérisé en ce que
le rayonnement électromagnétique (S) est produit à l'aide d'un laser.

7. Procédé suivant la revendication 6, caractérisé en ce que
le déplacement du faisceau laser sur le substrat (1) est susceptible d'être programmé librement.

8. Procédé suivant l'une des revendications précédentes, caractérisé en ce que
l'on utilise un substrat (1) tridimensionnel, moulé par injection et comportant des trous (2) de contact traversant obtenus par injection.
